(19) Europäisches Patentamt
European Patent Office
Office européen des brevets

(11) EP 3 780 132 A1

(12) DEMANDE DE BREVET EUROPEEN

(43) Date de publication:
17.02.2021 Bulletin 2021/07

(51) Int Cl.:
H01L 51/52 (2006.01)     G02B 5/04 (2006.01)
H01L 33/60 (2010.01)

(21) Numéro de dépôt: 20190881.1

(22) Date de dépôt: 13.08.2020

(84) Etats contractants désignés:
AL AT BE BG CH CY CZ DE DK EE ES FI FR GB
GR HR HU IE IS IT LI LT LU LV MC MK MT NL NO
PL PT RO RS SE SI SK SM TR
Etats d'extension désignés:
BA ME
Etats de validation désignés:
KH MA MD TN

(30) Priorité: 16.08.2019 FR 1909241

(71) Demandeur: Commissariat à l'Energie Atomique
et aux Energies
Alternatives
75015 Paris (FR)

(72) Inventeurs:
• QUESNEL, ETIENNE
  38054 GRENOBLE Cedex 09 (FR)
• CONSONNI, MARIANNE
  38054 GRENOBLE Cedex 09 (FR)
• MEUNIER, SYLVIA
  38054 GRENOBLE Cedex 09 (FR)
• RACINE, BENOIT
  38054 GRENOBLE Cedex 09 (FR)

(74) Mandataire: INNOV-GROUP
310, avenue Berthelot
69372 Lyon Cedex 08 (FR)

(54) **DISPOSITIF ELECTROLUMINESCENT**

(57)     Ce dispositif comporte :
- des première et seconde électrodes ($E_1$, $E_2$), au moins partiellement transparentes dans un domaine spectral ;
- une couche électroluminescente (EL), s'étendant entre les première et seconde électrodes ($E_1$, $E_2$), et adaptée pour émettre un rayonnement électromagnétique dans le domaine spectral, le rayonnement électromagnétique étant polarisé circulairement selon un premier sens de polarisation ;
- un substrat structuré (1), la première électrode ($E_1$) s'étendant entre le substrat structuré (1) et la couche électroluminescente (EL), le substrat structuré (1)

comprenant :
des motifs réfléchissants (10) dans le domaine spectral, et possédant une forme géométrique creuse adaptée de sorte que le rayonnement électromagnétique traversant la première électrode ($E_1$) se réfléchit sur les motifs réfléchissants (10) en conservant le premier sens de polarisation,
un matériau de remplissage (11), transparent dans le domaine spectral, et agencé pour remplir les motifs réfléchissants (10) de sorte que le substrat structuré (1) présente une surface plane.

Fig. 2

EP 3 780 132 A1

# Description

## Domaine technique

L'invention se rapporte au domaine technique des dispositifs électroluminescents, notamment organiques. Plus précisément, l'invention vise à obtenir un dispositif électroluminescent émettant un rayonnement électromagnétique polarisé circulairement avec un fort degré de polarisation.

L'invention trouve notamment son application dans l'imagerie en biologie et plus généralement dans le domaine de la santé, ou encore dans les afficheurs 2D et 3D.

## État de l'art

Un dispositif électroluminescent organique connu de l'état de la technique, notamment du document Zinna et al., « Highly Circularly Polarized Electroluminescence from a Chiral Europium Complex », Advanced Materials, vol.27, n°10, 2015, (ci-après D1) comporte :

- une première électrode, réfléchissante, réalisée en aluminium ;
- une seconde électrode, transparente, réalisée en ITO (« *Indium Tin Oxide* » en langue anglaise) ;
- une couche électroluminescente organique, formée entre les première et seconde électrodes, et adaptée pour émettre un rayonnement électromagnétique polarisé circulairement selon un premier sens de polarisation.

Un tel dispositif de l'état de la technique ne permet pas d'émettre un rayonnement électromagnétique polarisé circulairement, avec un fort degré de polarisation, en sortie de la seconde électrode.

En effet, la partie du rayonnement électromagnétique émis par la couche électroluminescente organique qui se réfléchit sur la première électrode possède un second sens de polarisation, opposé au premier sens de polarisation. Or, le degré de polarisation, noté g, vérifie la relation suivante :

$$g = 2 \frac{I_L - I_R}{I_L + I_R}$$

où :

- $I_R$ est l'intensité du rayonnement électromagnétique, polarisé circulairement selon le premier sens de polarisation, en sortie de la seconde électrode,
- $I_L$ est l'intensité du rayonnement électromagnétique, polarisé circulairement selon le second sens de polarisation, en sortie de la seconde électrode.

La réflexion de la partie du rayonnement électromagnétique émis par la couche électroluminescente organique sur la première électrode conduit à réduire le degré de polarisation g car $I_L$ est du même ordre de grandeur que $I_R$.

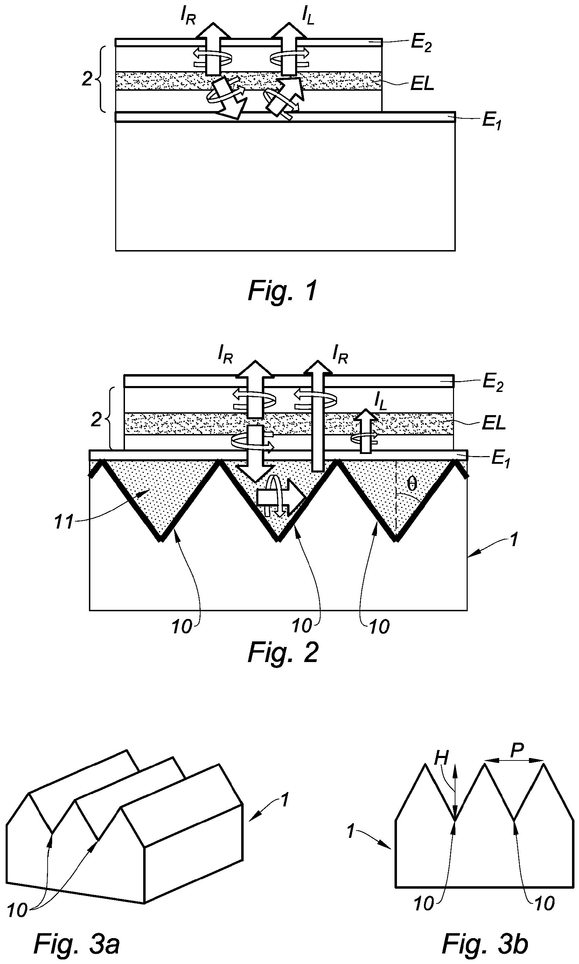

De plus, comme illustré à la figure 1 pour une architecture à émission vers le haut, un dispositif électroluminescent organique connu de l'état de la technique comporte :

- une première électrode $E_1$, réfléchissante ;
- une seconde électrode $E_2$, semi-transparente ;
- une couche électroluminescente EL organique, formée entre les première et seconde électrodes $E_1$, $E_2$, et adaptée pour émettre un rayonnement électromagnétique polarisé circulairement selon un premier sens de polarisation.

De la même façon, un tel dispositif de l'état de la technique ne permet pas d'émettre un rayonnement électromagnétique polarisé circulairement, avec un fort degré de polarisation, en sortie de la seconde électrode $E_2$. En effet, la partie du rayonnement électromagnétique émis par la couche électroluminescente EL organique qui se réfléchit sur la première électrode $E_1$ possède un second sens de polarisation, opposé au premier sens de polarisation. La réflexion de la partie du rayonnement électromagnétique émis par la couche électroluminescente EL organique sur la première électrode $E_1$ conduit à réduire le degré de polarisation g car $I_L$ est du même ordre de grandeur que $I_R$.

## Exposé de l'invention

L'invention vise à remédier en tout ou partie aux inconvénients précités. A cet effet, l'invention a pour objet un dispositif électroluminescent, comportant :

- des première et seconde électrodes, au moins partiellement transparentes dans un domaine spectral ;
- une couche électroluminescente, s'étendant entre les première et seconde électrodes, et adaptée pour émettre un rayonnement électromagnétique dans le domaine spectral, le rayonnement électromagnétique étant polarisé circulairement selon un premier sens de polarisation ;
- un substrat structuré, la première électrode s'étendant entre le substrat structuré et la couche électroluminescente, le substrat structuré comprenant :

  des motifs réfléchissants dans le domaine spectral, et possédant une forme géométrique creuse adaptée de sorte que le rayonnement électromagnétique traversant la première électrode se réfléchit sur les motifs réfléchissants en conservant le premier sens de polarisation, un matériau de remplissage, transparent dans le domaine spectral, et agencé pour remplir les motifs réfléchissants de sorte que le substrat structuré présente une surface plane.

Ainsi, un tel dispositif selon l'invention permet d'émettre un rayonnement électromagnétique polarisé circulairement selon le premier sens de polarisation, avec un fort degré de polarisation, en sortie de la seconde électrode. Cela est rendu possible grâce à une forme adaptée des motifs réfléchissants du substrat structuré qui permet de conserver le premier sens de polarisation.

En d'autres termes, on a $I_R \gg I_L$ où :

- $I_R$ est l'intensité du rayonnement électromagnétique, polarisé circulairement selon le premier sens de polarisation, en sortie de la seconde électrode,
- $I_L$ est l'intensité du rayonnement électromagnétique, polarisé circulairement selon le second sens de polarisation (opposé au premier sens de polarisation), en sortie de la seconde électrode.

En sortie de la seconde électrode, $I_R$ est due :

- à la transmission directe du rayonnement électromagnétique depuis la couche électroluminescente vers la seconde électrode,
- aux réflexions du rayonnement électromagnétique sur les motifs réfléchissants du substrat structuré.

En sortie de la seconde électrode, $I_L$ est due aux réflexions du rayonnement électromagnétique sur la première électrode. La première électrode étant semi-transparente ou transparente (donc peu réfléchissante), $I_L$ est donc très faible en sortie de la seconde électrode par rapport à $I_R$.

Par ailleurs, le matériau de remplissage permet un aplanissement du substrat structuré de manière à former aisément :

- la première électrode sur le substrat structuré pour une architecture à émission vers le haut, ou
- le substrat structuré sur la première électrode pour une architecture à émission vers le bas.

**Définitions**

- Par « au moins partiellement transparentes », on entend que la première électrode ou la seconde électrode est :

  semi-transparente, avec un coefficient de transmission en intensité, moyenné sur le domaine spectral, compris entre 30% et 70%, ou transparente, avec un coefficient de transmission en intensité, moyenné sur le domaine spectral, supérieur ou égal à 70%, de préférence supérieur ou égal à 80%, plus préférentiellement supérieur ou égal à 90%.

- L'expression « s'étendant entre » n'implique pas que la couche électroluminescente se trouve en contact avec les première et seconde électrodes. Le dispositif peut par exemple comporter des couches de transport (d'électrons et de trous) et des couches d'injection (d'électrons et de trous) s'étendant entre une électrode et la couche électroluminescente (dite couche émissive).
- Par « substrat », on entend un support physique autoporté. Par exemple, un substrat est classiquement une tranche (« *wafer* » en langue anglaise) découpée dans un lingot cristallin de matériau semi-conducteur.
- Par « substrat structuré », on entend que le substrat présente une surface non-plane (en l'absence de matériau de remplissage) délimitant un ensemble de motifs (reliefs).
- Par « réfléchissants », on entend que les motifs du substrat structuré possèdent un coefficient de réflexion en intensité, moyenné sur le domaine spectral, supérieur ou égal à 70%, de préférence supérieur ou égal à 80%, plus préférentiellement supérieur ou égal à 90%.
- Par « forme géométrique creuse », on entend que chacun des motifs réfléchissants du substrat structuré délimite une cavité.
- Par « transparent », on entend que le matériau de remplissage possède un coefficient de transmission en intensité, moyenné sur le domaine spectral, supérieur ou égal à 70%, de préférence supérieur ou égal à 80%, plus préférentiellement supérieur ou égal à 90%.

Le dispositif selon l'invention peut comporter une ou plusieurs des caractéristiques suivantes.

Selon une caractéristique de l'invention, la forme géométrique creuse des motifs réfléchissants est adaptée de sorte que le rayonnement électromagnétique traversant la première électrode se réfléchit sur les motifs réfléchissants N fois, N étant un nombre entier pair non nul.

En d'autres termes, la forme géométrique creuse des motifs réfléchissants autorise un nombre pair de réflexions entre le rayonnement électromagnétique traversant la première électrode et les motifs réfléchissants. Ainsi, le rayonnement électromagnétique traversant la première électrode conserve le premier sens de polarisation à l'issue du nombre pair de réflexions sur les motifs réfléchissants du substrat structuré. En effet, pour un couple de réflexions donné, la première réflexion inverse le sens de polarisation initial puis la seconde réflexion inverse de nouveau le sens de polarisation de manière à revenir au sens de polarisation initial.

Selon une caractéristique de l'invention, les motifs réfléchissants présentent au moins un profil en forme de V.

Par « profil », on entend une section transversale des motifs réfléchissants, c'est-à-dire suivant une direction perpendiculaire à la normale à la surface plane du substrat structuré.

Ainsi, le rayonnement électromagnétique traversant la première électrode conserve le premier sens de polarisation à l'issue de deux réflexions successives sur les motifs réfléchissants du substrat structuré. Plus précisément, le premier sens de polarisation est conservé à l'issue de deux réflexions successives sur les flancs de chaque motif réfléchissant du substrat structuré, les flancs présentant un profil en forme de V.

Les motifs réfléchissants peuvent présenter des premier et second profils en forme de V de sorte que le substrat structuré est bidirectionnel. Le premier profil s'étend suivant une première direction, perpendiculaire à la normale à la surface plane du substrat structuré. Le second profil s'étend suivant une seconde direction, perpendiculaire à la première direction, et perpendiculaire à la normale à la surface plane du substrat structuré.

Selon une caractéristique de l'invention, les motifs réfléchissants comportent des flancs inclinés d'un angle compris entre 30° et 60°, de préférence compris entre 40° et 50°, par rapport à la normale à la surface plane du substrat structuré.

Ainsi, un avantage procuré par la plage [40°-50°] est d'augmenter significativement le couplage optique de sortie du dispositif pour l'extraction d'un rayonnement électromagnétique ayant subi deux réflexions sur les motifs réfléchissants, l'optimal étant à 45°.

Selon une caractéristique de l'invention, les motifs réfléchissants sont de forme concave, et le substrat structuré comporte une matrice de microlentilles formant le matériau de remplissage.

Ainsi, un avantage procuré est d'augmenter significativement le couplage optique de sortie du dispositif.

Selon une caractéristique de l'invention, les motifs réfléchissants sont répartis de manière périodique suivant une direction perpendiculaire à la normale à la surface plane du substrat structuré.

Ainsi, un avantage procuré est de faciliter la fabrication du substrat structuré à l'échelle industrielle.

Selon une caractéristique de l'invention, le rayonnement électromagnétique possède une longueur d'onde dominante, notée λ, et les motifs réfléchissants présentent une période spatiale supérieure à 5 λ, de préférence supérieure à 10 λ.

- Par « longueur d'onde dominante », on entend la longueur d'onde du domaine spectral qui correspond à la fréquence transportant le plus d'énergie, ou qui correspond à la fréquence centrale de la plage de fréquences transportant le plus d'énergie.

Ainsi, un avantage procuré est de s'affranchir de phénomènes de diffraction.

Selon une caractéristique de l'invention, le rayonnement électromagnétique possède une longueur d'onde dominante, notée λ, et les motifs réfléchissants présentent une profondeur supérieure à 5 λ, de préférence supérieure à 10 λ.

Par « profondeur », on entend la dimension maximale des motifs réfléchissants suivant la normale à la surface plane du substrat structuré.

Ainsi, un avantage procuré est de s'affranchir de phénomènes de diffraction.

Selon une caractéristique de l'invention, la profondeur, notée H, et la période spatiale, notée P, vérifient H=P/2.

Ainsi, les motifs réfléchissants présentent un profil en forme de V avec des flancs inclinés d'un angle de 45°, chaque motif définissant un triangle rectangle isocèle, P étant l'hypoténuse, H étant la hauteur du triangle.

Selon une caractéristique de l'invention, les motifs réfléchissants sont réalisés dans un matériau métallique, de préférence choisi parmi Ag, Al.

Selon une caractéristique de l'invention, la couche électroluminescente est réalisée dans un matériau organique chiral.

Selon une caractéristique de l'invention, les première et seconde électrodes sont réalisées dans un oxyde transparent conducteur.

Par « oxyde transparent conducteur », on entend un oxyde possédant :

- un coefficient de transmission en intensité, moyenné sur le domaine spectral, supérieur ou égal à 70%, de préférence supérieur ou égal à 80%, plus préférentiellement supérieur ou égal à 90%,
- une conductivité électrique à 300 K supérieure ou égale à $10^2$ S/cm.

Selon une caractéristique de l'invention, le domaine spectral est choisi parmi :

- le domaine visible avec des longueurs d'onde comprises entre 400 nm et 780 nm,
- le domaine UV-A avec des longueurs d'onde comprises entre 315 nm et 400 nm,
- le domaine infrarouge proche avec des longueurs d'onde comprises entre 780 nm et 3 μm.

**Brève description des dessins**

D'autres caractéristiques et avantages apparaîtront dans l'exposé détaillé de différents modes de réalisation de l'invention, l'exposé étant assorti d'exemples et de références aux dessins joints.

Figure 1 est une vue schématique en coupe d'un dispositif électroluminescent de l'état de la technique.
Figure 2 est une vue schématique en coupe d'un dispositif électroluminescent selon l'invention.
Figures 3a et 3b sont des vues schématiques, respectivement en perspective et en coupe, d'un substrat structuré (en l'absence d'un matériau de remplissage) appartenant à un dispositif électroluminescent selon l'invention.

Figures 4a à 4g sont des vues schématiques en coupe illustrant un premier procédé de fabrication d'un dispositif électroluminescent selon l'invention.

Figures 5a à 5c sont des vues schématiques en coupe illustrant un deuxième procédé de fabrication d'un dispositif électroluminescent selon l'invention.

Figures 6a à 6f sont des vues schématiques en coupe illustrant un troisième procédé de fabrication d'un dispositif électroluminescent selon l'invention.

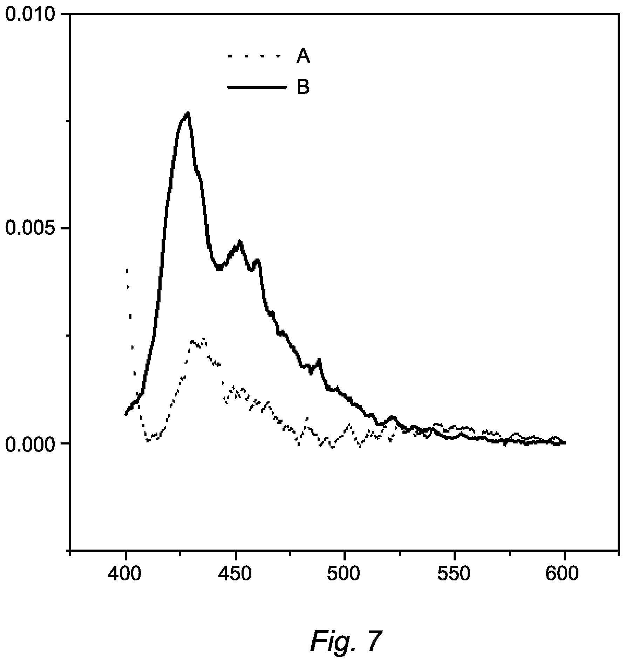

Figure 7 est un graphique représentant en abscisses la longueur d'onde (en nm) et en ordonnées l'intensité de photoluminescence (unité arbitraire), pour un substrat structuré (B) et pour un substrat plan (A) exposés à un rayonnement ultraviolet. Le substrat structuré (B) est un substrat de silicium comportant des motifs réfléchissants, de forme géométrique creuse, réalisés en Ag (profil en V, flancs inclinés d'un angle de 45°) et remplis d'une résine transparente. Le substrat B est un substrat de silicium sur lequel est formée une couche plane en Ag. Les substrats (A, B) sont revêtus d'une couche chirale organique de type hélicène. Ce graphique illustre l'influence d'un substrat structuré (B) d'un dispositif selon l'invention -par rapport à un substrat plan (A)- sur l'intensité du rayonnement électromagnétique polarisé circulairement en sortie de la couche chirale organique.

## Exposé détaillé des modes de réalisation

Les éléments identiques ou assurant la même fonction porteront les mêmes références pour les différents modes de réalisation, par souci de simplification.

Un objet de l'invention est un dispositif électroluminescent, comportant :

- des première et seconde électrodes $E_1$, $E_2$, au moins partiellement transparentes dans un domaine spectral ;
- une couche électroluminescente EL, s'étendant entre les première et seconde électrodes $E_1$, $E_2$, et adaptée pour émettre un rayonnement électromagnétique dans le domaine spectral, le rayonnement électromagnétique étant polarisé circulairement selon un premier sens de polarisation ;
- un substrat structuré 1, la première électrode $E_1$ s'étendant entre le substrat structuré 1 et la couche électroluminescente EL, le substrat structuré 1 comprenant :

  des motifs réfléchissants 10 dans le domaine spectral, et possédant une forme géométrique creuse adaptée de sorte que le rayonnement électromagnétique traversant la première électrode $E_1$ se réfléchit sur les motifs réfléchissants

10 en conservant le premier sens de polarisation,

  un matériau de remplissage 11, transparent dans le domaine spectral, et agencé pour remplir les motifs réfléchissants 10 de sorte que le substrat structuré 1 présente une surface plane.

## Première et seconde électrodes

Pour une architecture à émission vers le bas, la seconde électrode $E_2$ est transparente, avec un coefficient de transmission en intensité, moyenné sur le domaine spectral, supérieur ou égal à 70%, de préférence supérieur ou égal à 80%, plus préférentiellement supérieur ou égal à 90%. La première électrode $E_1$ est préférentiellement transparente, avec un coefficient de transmission en intensité, moyenné sur le domaine spectral, supérieur ou égal à 70%, de préférence supérieur ou égal à 80%, plus préférentiellement supérieur ou égal à 90%. Les première et seconde électrodes $E_1$, $E_2$ peuvent être réalisées dans un oxyde transparent conducteur. La seconde électrode $E_2$ peut être réalisée en oxyde d'indium-étain (ITO pour *« Indium Tin Oxide »* en langue anglaise).

Pour une architecture à émission vers le haut, la seconde électrode $E_2$ est semi-transparente, avec un coefficient de transmission en intensité, moyenné sur le domaine spectral, compris entre 30% et 70%. La seconde électrode $E_2$ peut être réalisée dans un matériau métallique, tel que Ag, Al. La première électrode $E_1$ est préférentiellement transparente, avec un coefficient de transmission en intensité, moyenné sur le domaine spectral, supérieur ou égal à 70%, de préférence supérieur ou égal à 80%, plus préférentiellement supérieur ou égal à 90%. La première électrode $E_1$ peut être réalisée dans un oxyde transparent conducteur.

## Couche électroluminescente

La couche électroluminescente EL est de préférence organique. La couche électroluminescente EL organique est avantageusement réalisée dans un matériau organique chiral. A titre d'exemples non limitatifs, le matériau organique chiral peut être :

- un hélicène, tel qu'un platinahélicène,
- le poly(fluorène-alt-benzothiadiazole) chiral (c-PFBT) -où « alt » désigne un copolymère alterné-,
- un complexe de lanthanides,
- un complexe d'iridium (III).

D'autres exemples de matériaux organiques adaptés pour émettre un rayonnement électromagnétique polarisé circulairement sont donnés dans le document J. Han et al., « Recent Progress on Circularly Polarized Luminescent Materials for Organic Oproelectronic Devices », Advanced Optical Materials, vol. 6, 17, 2018.

Selon une alternative, la couche électroluminescente EL peut être inorganique de manière à obtenir une diode électroluminescente de type spin-LED. A titre d'exemples non limitatifs, la couche électroluminescente EL inorganique peut être réalisée sous la forme d'un puits quantique, par exemple InGaN/GaN ou AlGaAs/GaAs. Le cas échéant, la seconde électrode $E_2$ est réalisée dans un matériau magnétique de manière à polariser circulairement la lumière émise par la couche électroluminescente EL inorganique, le matériau magnétique pouvant être par exemple MgO/FeCo. Le cas échéant, le substrat structuré 1 est de préférence réalisé en silicium.

Le rayonnement électromagnétique émis par la couche électroluminescente EL peut posséder une longueur d'onde dominante, notée $\lambda$. Le domaine spectral du rayonnement électromagnétique émis par la couche électroluminescente EL est avantageusement choisi parmi :

- le domaine visible avec des longueurs d'onde comprises entre 400 nm et 780 nm,
- le domaine UV-A avec des longueurs d'onde comprises entre 315 nm et 400 nm,
- le domaine infrarouge proche avec des longueurs d'onde comprises entre 780 nm et 3 $\mu$m.

La couche électroluminescente EL n'est préférentiellement pas en contact avec les première et seconde électrodes $E_1$, $E_2$. Le dispositif peut par exemple comporter des couches de transport (d'électrons et de trous) et des couches d'injection (d'électrons et de trous) s'étendant entre une électrode $E_1$, $E_2$ et la couche électroluminescente EL (dite couche émissive).

**Substrat structuré**

La forme géométrique creuse des motifs réfléchissants 10 est avantageusement adaptée de sorte que le rayonnement électromagnétique traversant la première électrode $E_1$ se réfléchit sur les motifs réfléchissants N fois, N étant un nombre entier pair non nul.

Les motifs réfléchissants 10 présentent avantageusement au moins un profil en forme de V. Les motifs réfléchissants 10 comportent avantageusement des flancs inclinés d'un angle $\theta$ compris entre 30° et 60°, de préférence compris entre 40° et 50°, plus préférentiellement égal à 45°, par rapport à la normale à la surface plane du substrat structuré 1. L'influence d'un substrat structuré avec des motifs réfléchissants en forme de V (flancs inclinés d'un angle de 45°) est manifeste à la figure 7. Les inventeurs ont constaté une augmentation de l'intensité du rayonnement électromagnétique polarisé de l'ordre d'un facteur 3 par rapport à un substrat plan.

Les motifs réfléchissants 10 sont avantageusement répartis de manière périodique suivant une direction perpendiculaire à la normale à la surface plane du substrat structuré 1. Les motifs réfléchissants 10 présentent avantageusement une période spatiale supérieure à 5 $\lambda$, de préférence supérieure à 10 $\lambda$. Les motifs réfléchissants 10 présentent avantageusement une profondeur supérieure à 5 $\lambda$, de préférence supérieure à 10 $\lambda$. La profondeur, notée H, et la période spatiale, notée P, vérifient avantageusement la relation suivante : H=P/2.

Les motifs réfléchissants 10 sont avantageusement réalisés dans un matériau métallique, de préférence choisi parmi Ag, Al. Le substrat structuré 1 peut être réalisé dans un matériau plastique ou en silicium. Les motifs du substrat structuré 1 peuvent être métallisés de manière à obtenir les motifs réfléchissants 10.

Selon un mode de réalisation, les motifs réfléchissants 10 sont de forme concave, et le substrat structuré 1 comporte une matrice de microlentilles formant le matériau de remplissage 11. Selon une alternative, le matériau de remplissage 11 peut être un matériau composite (oxyde/polymère photo-polymérisable) formé par un procédé sol-gel.

Le matériau de remplissage 11 est avantageusement en contact (i.e. en contact direct) avec la première électrode $E_1$, au sens où il n'existe aucun élément intercalé entre le matériau de remplissage 11 et la première électrode $E_1$.

**Procédé de fabrication du dispositif pour une architecture à émission vers le haut**

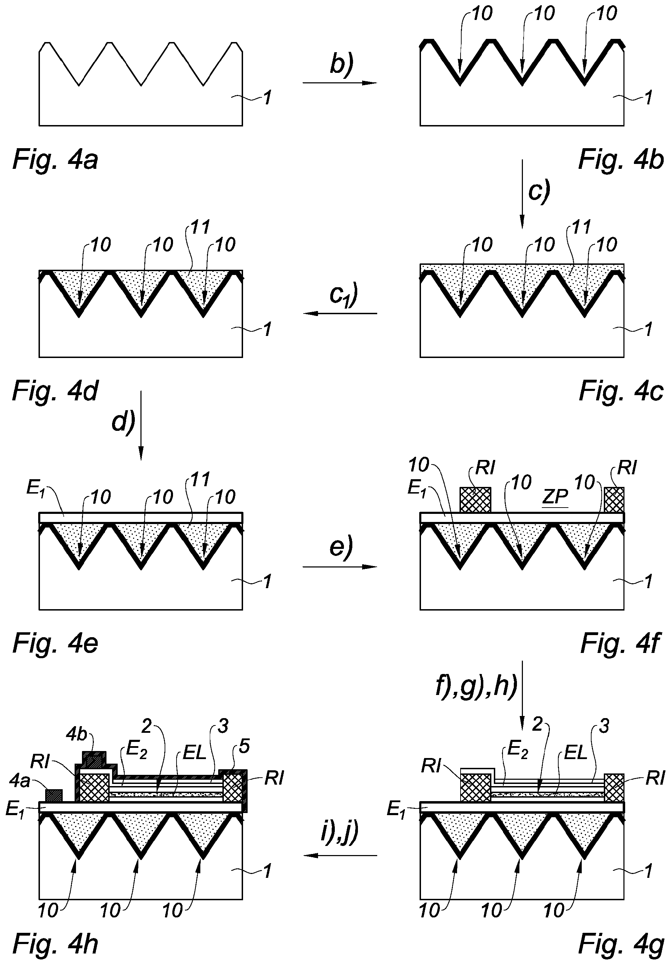

Comme illustré aux figures 4a à 4h, un procédé de fabrication d'un dispositif électroluminescent conforme à l'invention comporte les étapes :

a) prévoir un substrat structuré 1, comportant des motifs possédant une forme géométrique creuse ;

b) métalliser les motifs de manière à obtenir des motifs réfléchissants 10 ;

c) former un matériau de remplissage 11, transparent dans un domaine spectral, à l'intérieur des motifs réfléchissants 10 de sorte que le substrat structuré 1 présente une surface plane ;

d) former une première électrode $E_1$, transparente dans le domaine spectral, sur la surface plane du substrat structuré 1 ;

e) former des zones de pixels ZP sur la première électrode $E_1$ par une gravure d'une résine RI électriquement isolante ;

f) former un empilement 2 de couches sur les zones de pixels ZP de la première électrode $E_1$, l'empilement 2 comprenant une couche électroluminescente EL adaptée pour émettre un rayonnement électromagnétique dans le domaine spectral, le rayonnement électromagnétique étant polarisé circulairement selon un premier sens de polarisation ;

g) former une seconde électrode $E_2$, semi-transparente dans le domaine spectral, sur l'empilement 2 ;

h) former une première couche d'encapsulation 3 sur la seconde électrode $E_2$ ;

i) former des premiers et seconds plots de contact 4a, 4b reliés électriquement respectivement aux pre-

mière et seconde électrodes $E_1$, $E_2$ ;
j) former une seconde couche d'encapsulation 5 sur la première couche d'encapsulation 3.

L'étape a) peut être exécutée en utilisant un film plastique rainuré, par exemple un film BEF II de la marque Vikuiti™. Le film plastique rainuré peut présenter une épaisseur de l'ordre de 150 μm. La forme géométrique creuse des motifs du substrat structuré 1 prévu lors de l'étape a) est adaptée de sorte que le rayonnement électromagnétique traversant la première électrode $E_1$ se réfléchit sur les motifs réfléchissants 10 en conservant le premier sens de polarisation. L'étape b) peut être exécutée par une métallisation de type « pleine plaque », de manière à former une fine couche métallique sur les motifs, par exemple en argent, d'une épaisseur comprise entre 50 nm et 100 nm. L'étape c) peut être exécutée par une enduction (« *Slot Die Coating* » en langue anglaise) d'une résine composite organique/inorganique, suivie d'une réticulation sous l'action d'un rayonnement UV. L'étape c) est de préférence suivie d'une étape $c_1$) de polissage mécano-chimique. La première couche d'encapsulation 3 formée lors de l'étape h) peut être réalisée en SiO. La seconde couche d'encapsulation 5 formée lors de l'étape j) peut être déposée par ALD (« *Atomic Layer Deposition* » en langue anglaise).

## Procédé de fabrication du dispositif pour une architecture à émission vers le bas

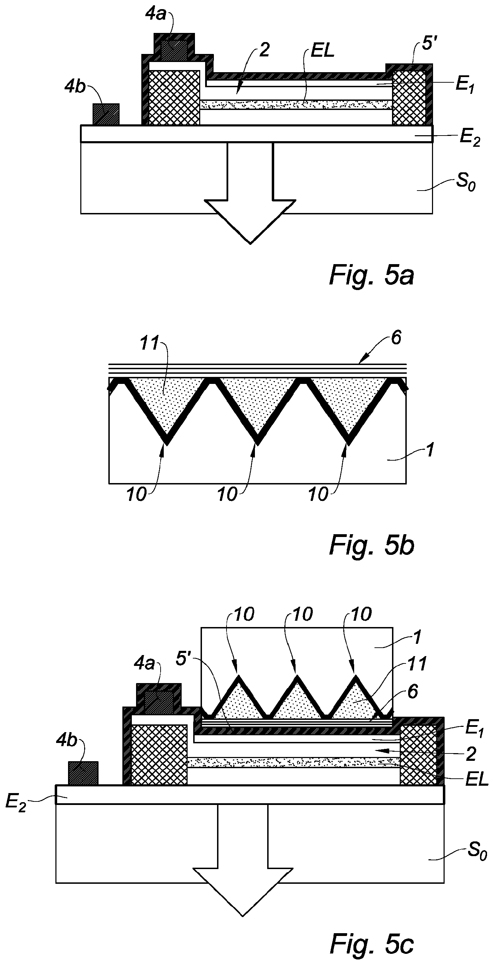

Comme illustré aux figures 5a à 5c, un procédé de fabrication d'un dispositif électroluminescent conforme à l'invention comporte les étapes :

a') prévoir une diode électroluminescente comportant successivement :

- un substrat $S_0$ de verre,
- une électrode (seconde électrode $E_2$), transparente dans un domaine spectral,
- un empilement 2 de couches, comprenant une couche électroluminescente EL adaptée pour émettre un rayonnement électromagnétique dans le domaine spectral, le rayonnement électromagnétique étant polarisé circulairement selon un premier sens de polarisation,
- une électrode (première électrode $E_1$), transparente dans un domaine spectral,
- une couche d'encapsulation 5' ;

b') prévoir un substrat structuré 1, conformément aux étapes a), b) et c) décrites précédemment ;
c') recouvrir le substrat structuré 1 d'une structure tri-couche 6 de manière à encapsuler le substrat structuré 1, la structure tri-couche 6 pouvant être du type $Al_2O_3$/polymère/$Al_2O_3$, la structure tri-couche 6 présentant une épaisseur inférieure à 1 μm ;
d') transférer sur le substrat structuré 1 sur la couche d'encapsulation 5' par l'intermédiaire de la structure tri-couche 6, l'étape d') pouvant être exécutée par collage/laminage.

## Procédé de fabrication du dispositif pour un afficheur

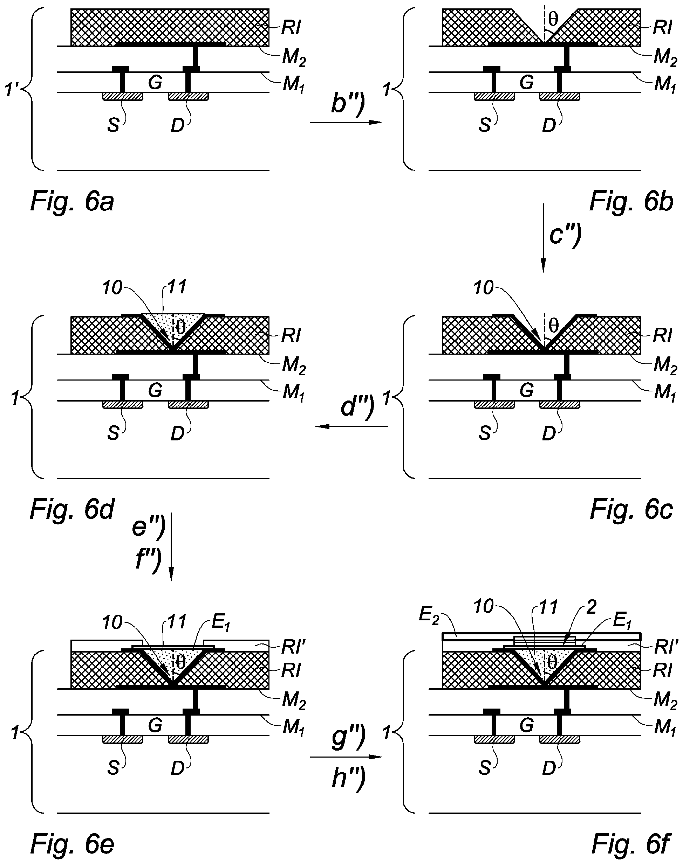

Comme illustré aux figures 6a à 6f, un procédé de fabrication d'un dispositif électroluminescent conforme à l'invention comporte les étapes :

a") prévoir un substrat 1' de type CMOS (« *Complementary Métal Oxide Semi-conductor* » en langue anglaise), recouvert d'une résine RI électriquement isolante, le substrat 1' comprenant un circuit CMOS avec plusieurs niveaux de métallisation $M_1$, $M_2$, et avec des couples de transistors MOSFET (« *Métal Oxide Semiconductor Field Effect Transistor* » en langue anglaise), un seul transistor étant visible aux figures 6a à 6f, comprenant chacun une source S, une grille G et un drain D ;
b") graver la résine RI électriquement isolante de manière à former des zones de pixels ; l'étape b") étant exécutée de manière à obtenir des motifs possédant des flancs inclinés d'un angle θ compris entre 30° et 60°, de préférence compris entre 40° et 50°, par rapport à la normale au substrat 1' ; le substrat 1' de type CMOS étant ainsi structuré à l'issue de l'étape b") ;
c") métalliser les motifs de manière à obtenir des motifs réfléchissants 10 ;
d") former un matériau de remplissage 11, transparent dans un domaine spectral, à l'intérieur des motifs réfléchissants 10 de sorte que le substrat structuré 1 présente une surface plane ;
e") former une première électrode $E_1$, transparente dans le domaine spectral, sur la surface plane du substrat structuré 1, en regard des zones de pixels ;
f") former une résine RI' additionnelle électriquement isolante sur la surface plane du substrat structuré, entre les zones de pixels, de manière à éviter les courts-circuits entre les pixels ;
g") former un empilement 2 de couches sur la première électrode $E_1$, l'empilement 2 comprenant une couche électroluminescente EL adaptée pour émettre un rayonnement électromagnétique dans le domaine spectral, le rayonnement électromagnétique étant polarisé circulairement selon un premier sens de polarisation ;
h") former une seconde électrode $E_2$, semi-transparente dans le domaine spectral, sur l'empilement 2 ;
i") former une couche d'encapsulation (non illustré) sur la seconde électrode $E_2$.

La résine RI électriquement isolante peut être une couche diélectrique réalisée en SiN ou $SiO_2$. La résine RI électriquement isolante présente préférentiellement une épaisseur supérieure à 5 μm. Les motifs ob-

tenus lors de l'étape b") possèdent une forme géométrique creuse adaptée de sorte que le rayonnement électromagnétique traversant la première électrode $E_1$ se réfléchit sur les motifs réfléchissants 10 en conservant le premier sens de polarisation. Lors de l'étape b"), le dernier niveau de métallisation $M_2$ assure le rôle de couche d'arrêt de gravure. L'étape d") peut être exécutée par une enduction (« *Slot Die Coating* » en langue anglaise) d'une résine composite organique/inorganique, suivie d'une réticulation sous l'action d'un rayonnement UV. L'étape d") est de préférence suivie d'une étape de polissage mécano-chimique.

L'invention ne se limite pas aux modes de réalisation exposés. L'homme du métier est mis à même de considérer leurs combinaisons techniquement opérantes, et de leur substituer des équivalents.

## Revendications

1. Dispositif électroluminescent, comportant :

   - des première et seconde électrodes ($E_1$, $E_2$), au moins partiellement transparentes dans un domaine spectral ;
   - une couche électroluminescente (EL), s'étendant entre les première et seconde électrodes ($E_1$, $E_2$), et adaptée pour émettre un rayonnement électromagnétique dans le domaine spectral, le rayonnement électromagnétique étant polarisé circulairement selon un premier sens de polarisation ;
   - un substrat structuré (1), la première électrode ($E_1$) s'étendant entre le substrat structuré (1) et la couche électroluminescente (EL), le substrat structuré (1) comprenant :

     des motifs réfléchissants (10) dans le domaine spectral, et possédant une forme géométrique creuse adaptée de sorte que le rayonnement électromagnétique traversant la première électrode ($E_1$) se réfléchit sur les motifs réfléchissants (10) en conservant le premier sens de polarisation,
     un matériau de remplissage (11), transparent dans le domaine spectral, et agencé pour remplir les motifs réfléchissants (10) de sorte que le substrat structuré (1) présente une surface plane.

2. Dispositif selon la revendication 1, dans lequel la forme géométrique creuse des motifs réfléchissants (10) est adaptée de sorte que le rayonnement électromagnétique traversant la première électrode ($E_1$) se réfléchit sur les motifs réfléchissants (10) N fois, N étant un nombre entier pair non nul.

3. Dispositif selon la revendication 1 ou 2, dans lequel les motifs réfléchissants (10) présentent au moins un profil en forme de V.

4. Dispositif selon l'une des revendications 1 à 3, dans lequel les motifs réfléchissants (10) comportent des flancs inclinés d'un angle compris entre 30° et 60°, de préférence compris entre 40° et 50°, par rapport à la normale à la surface plane du substrat structuré (1).

5. Dispositif selon la revendication 1 ou 2, dans lequel les motifs réfléchissants (10) sont de forme concave, et le substrat structuré (1) comporte une matrice de microlentilles formant le matériau de remplissage (11).

6. Dispositif selon l'une des revendications 1 à 5, dans lequel les motifs réfléchissants (10) sont répartis de manière périodique suivant une direction perpendiculaire à la normale à la surface plane du substrat structuré (1).

7. Dispositif selon la revendication 6, dans lequel le rayonnement électromagnétique possède une longueur d'onde dominante, notée $\lambda$, et les motifs réfléchissants (10) présentent une période spatiale supérieure à 5 $\lambda$, de préférence supérieure à 10 $\lambda$.

8. Dispositif selon l'une des revendications 1 à 7, dans lequel le rayonnement électromagnétique possède une longueur d'onde dominante, notée $\lambda$, et les motifs réfléchissants (10) présentent une profondeur supérieure à 5 $\lambda$, de préférence supérieure à 10 $\lambda$.

9. Dispositif selon la revendication 8 en combinaison avec la revendication 7, dans lequel la profondeur, notée H, et la période spatiale, notée P, vérifient H=P/2.

10. Dispositif selon l'une des revendications 1 à 9, dans lequel les motifs réfléchissants (10) sont réalisés dans un matériau métallique, de préférence choisi parmi Ag, Al.

11. Dispositif selon l'une des revendications 1 à 10, dans lequel la couche électroluminescente (EL) est réalisée dans un matériau organique chiral.

12. Dispositif selon l'une des revendications 1 à 11, dans lequel les première et seconde électrodes ($E_1$, $E_2$) sont réalisées dans un oxyde transparent conducteur.

13. Dispositif selon l'une des revendications 1 à 12, dans lequel le domaine spectral est choisi parmi :

    - le domaine visible avec des longueurs d'onde comprises entre 400 nm et 780 nm,

- le domaine UV-A avec des longueurs d'onde comprises entre 315 nm et 400 nm,
- le domaine infrarouge proche avec des longueurs d'onde comprises entre 780 nm et 3 $\mu$m.

$I_R$   $I_L$

$E_2$

2

EL

$E_1$

**Fig. 1**

$I_R$   $I_R$

$E_2$

2   $I_L$

EL

$E_1$

θ

11

1

10   10   10

**Fig. 2**

1

10

**Fig. 3a**

H   P

1

10   10

**Fig. 3b**

Fig. 4a

b) →

Fig. 4b

↓ c)

← c₁)

Fig. 4d

Fig. 4c

↓ d)

Fig. 4e

e) →

Fig. 4f

f),g),h) ↓

← i),j)

Fig. 4h

Fig. 4g

*Fig. 5a*

*Fig. 5b*

*Fig. 5c*

Fig. 6a

Fig. 6b

Fig. 6d

Fig. 6c

Fig. 6e

Fig. 6f

*Fig. 7*

Europäisches
Patentamt

European
Patent Office

Office européen
des brevets

# RAPPORT DE RECHERCHE EUROPEENNE

Numéro de la demande

EP 20 19 0881

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | EP 3 503 224 A1 (SAMSUNG ELECTRONICS CO LTD [KR]; UNIV LELAND STANFORD JUNIOR [US]) 26 juin 2019 (2019-06-26) * alinéas [0030], [0035], [0037], [0040], [0047], [0048]; figures 7,8 * ----- | 1,6,9, 10,13 | INV. H01L51/52 G02B5/04 H01L33/60 |
| Y | US 2012/200221 A1 (INOUE HIROYASU [JP]) 9 août 2012 (2012-08-09) * alinéa [0168]; figures 1,2 * * alinéas [0120], [0121]; figure 6 * * alinéa [0107]; figure 10 * * alinéas [0049], [0070], [0080], [0081], [0082], [0093], [0097], [0114], [0149], [0164] * * alinéas [0133], [0140]; figure 14 * ----- | 1-8, 10-13 | |
| Y | WO 2010/032651 A1 (FUJIFILM CORP [JP]; USAMI YOSHIHISA [JP]) 25 mars 2010 (2010-03-25) * figures 1,2 * * page 24, ligne 21 * * page 26, lignes 9-11, 18 * * page 28, ligne 19 - ligne 20 * * page 29, ligne 5 * * page 11, ligne 16 * * page 23, ligne 4 - ligne 7 * * page 20, ligne 2 * * page 16, ligne 6 - ligne 13 * * page 17, ligne 11 - ligne 12 * ----- -/-- | 1-4,6,7, 10,12,13 | DOMAINES TECHNIQUES RECHERCHES (IPC) H01L G02B |

Le présent rapport a été établi pour toutes les revendications

| Lieu de la recherche | Date d'achèvement de la recherche | Examinateur |
|---|---|---|
| Munich | 14 décembre 2020 | Pusch, Catharina |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

page 1 de 2

Europäisches
Patentamt

European
Patent Office

Office européen
des brevets

**RAPPORT DE RECHERCHE EUROPEENNE**

Numéro de la demande

EP 20 19 0881

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | WO 2010/045606 A1 (BLOOMINESCENCE INC [US]; SHANKS MARK [US]) 22 avril 2010 (2010-04-22) | 1,11-13 | |
| Y | * page 9, ligne 20 - page 10, ligne 10; figure 3 * <br> * page 10, ligne 11 - ligne 23; figure 4 * <br> * figure 6 * <br> * page 12, lignes 22,31 * <br> * page 8, lignes 13, 25 - ligne 27 * <br> * page 17, ligne 1 - ligne 4 * <br> * page 24, lignes 31,32 * <br> * page 22, ligne 23 - page 23, ligne 6 * <br> * page 6, ligne 27 - ligne 31 * <br>----- | 1-8, 10-13 | |
| Y | JP 2000 195673 A (SANYO ELECTRIC CO) 14 juillet 2000 (2000-07-14) <br> * alinéa [0024] * <br>----- | 1-8, 10-13 | |
| Y | US 2014/042409 A1 (OHYAMA TSUYOSHI [JP]) 13 février 2014 (2014-02-13) <br> * alinéa [0082]; figure 2 * <br>----- | 1 | |

DOMAINES TECHNIQUES RECHERCHES (IPC)

Le présent rapport a été établi pour toutes les revendications

| Lieu de la recherche | Date d'achèvement de la recherche | Examinateur |
|---|---|---|
| Munich | 14 décembre 2020 | Pusch, Catharina |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons

& : membre de la même famille, document correspondant

EPO FORM 1503 03.82 (P04C02)

## ANNEXE AU RAPPORT DE RECHERCHE EUROPEENNE
### RELATIF A LA DEMANDE DE BREVET EUROPEEN NO.

EP 20 19 0881

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

14-12-2020

| Document brevet cité au rapport de recherche | | Date de publication | Membre(s) de la famille de brevet(s) | | Date de publication |
|---|---|---|---|---|---|
| EP 3503224 | A1 | 26-06-2019 | CN | 110034240 A | 19-07-2019 |
| | | | EP | 3503224 A1 | 26-06-2019 |
| | | | US | 2019198817 A1 | 27-06-2019 |
| US 2012200221 | A1 | 09-08-2012 | JP WO2011046144 A1 | | 07-03-2013 |
| | | | TW | 201121360 A | 16-06-2011 |
| | | | US | 2012200221 A1 | 09-08-2012 |
| | | | WO | 2011046144 A1 | 21-04-2011 |
| WO 2010032651 | A1 | 25-03-2010 | CN | 102160460 A | 17-08-2011 |
| | | | EP | 2356880 A1 | 17-08-2011 |
| | | | JP | 5288966 B2 | 11-09-2013 |
| | | | JP | 2010073665 A | 02-04-2010 |
| | | | TW | 201023668 A | 16-06-2010 |
| | | | US | 2011180823 A1 | 28-07-2011 |
| | | | WO | 2010032651 A1 | 25-03-2010 |
| WO 2010045606 | A1 | 22-04-2010 | CA | 2740988 A1 | 22-04-2010 |
| | | | CN | 102217025 A | 12-10-2011 |
| | | | EP | 2370985 A1 | 05-10-2011 |
| | | | JP | 2012506129 A | 08-03-2012 |
| | | | KR | 20110095866 A | 25-08-2011 |
| | | | US | 2010096617 A1 | 22-04-2010 |
| | | | WO | 2010045606 A1 | 22-04-2010 |
| JP 2000195673 | A | 14-07-2000 | AUCUN | | |
| US 2014042409 | A1 | 13-02-2014 | AUCUN | | |

EPO FORM P0460

Pour tout renseignement concernant cette annexe : voir Journal Officiel de l'Office européen des brevets, No.12/82

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **ZINNA et al.** Highly Circularly Polarized Electroluminescence from a Chiral Europium Complex. *Advanced Materials,* 2015, vol. 27 (10

- **J. HAN et al.** Recent Progress on Circularly Polarized Luminescent Materials for Organic Oproelectronic Devices. *Advanced Optical Materials,* 2018, vol. 6, 17